Europäisches Patentamt

European Patent Office

Office européen des brevets

(19)

(11) Veröffentlichungsnummer: **0 175 215**
A1

(12) # EUROPÄISCHE PATENTANMELDUNG

(21) Anmeldenummer: 85111180.7

(22) Anmeldetag: 04.09.85

(51) Int. Cl.⁴: **H 01 L 29/78**

(30) Priorität: 06.09.84 DE 3432817
07.02.85 DE 3504234

(43) Veröffentlichungstag der Anmeldung: 26.03.86
**Patentblatt 86/13**

(84) Benannte Vertragsstaaten: DE FR GB SE

(71) Anmelder: **Siemens Aktiengesellschaft, Berlin und München Wittelsbacherplatz 2, D-8000 München 2 (DE)**

(72) Erfinder: **Pfleiderer, Hans, Dr., Oberhofer Platz 4, D-8000 München 40 (DE)**
Erfinder: **Kusian, Wilhelm, Dipl.-Phys., Hans-Huber-Strasse 18, D-8034 Germering (DE)**

(54) Dünnschicht-Feldeffekt-Halbleiterbauelement.

(57) Das Feldeffekt-Halbleiterbauelement stellt einen Dünn-schicht-Transistor dar, bei dem die Source-Basis (3, 4)- und Drain-Basis (2, 4)-Kontakte als ohmsche Kontakte ausgebildet sind, die Dünnschicht-Halbleiterbasis (4) schwach dotiert oder auch eigenleitend ist und die der Gate-Elektrode (6) gegenüberliegende Basisrückseite eine fixe Grenzflächenladung (7) trägt, die eine Majoritätsträgerverarmungszone schafft. In einer Variante kann auch eine zweite Gate-Elektrode (6a) auf der dem isolierenden Substrat (1) zugewandten Seite der An-ordnung vorgesehen sein. Je nach Polarität und Größe der Drain (2)- und Gate (6)-Spannungen gegen Source (3) ist der Kanal n- oder p-leitend. Damit eröffnen sich neuartige schal-tungstechnische Perspektiven.

Siemens Aktiengesellschaft
Berlin und München

Unser Zeichen
VPA 84 P 8035 E

Feldeffekt-Halbleiterbauelement.

BEZEICHNUNG GEÄNDERT
siehe Titelseite

Die Erfindung bezieht sich auf ein Feldeffekt-Halbleiterbauelement in Dünnschichtbauweise mit einer auf der Oberfläche eines isolierenden Substrats aufgebrachten Halbleitermaterialschicht als Basisschicht, die zwischen zwei als Source und Drain wirkenden Bereichen einen leitenden Kanal bildet, dessen Vorderseite von einer Steuerelektrode (Gate) durch eine elektrisch isolierende Zwischenschicht getrennt ist.

Feldeffekt-Transistoren (FETs) sind Halbleiterbauelemente zur Verstärkung von Gleich- und Wechselspannungen. Dabei bilden eine Metallelektrode, eine Isolierschicht und ein Halbleiter eine kondensatorähnliche Anordnung (MIS-Struktur). Der Halbleiter ist zusätzlich mit zwei Kontakten Source (= Quelle) und Drain (= Senke) versehen, wozu noch ein dritter Anschluß, Gate (= Gitter) genannt, an der Metallelektrode kommt. Durch Anlegen eines positiven bzw. negativen Potentials am Gate werden im Oberflächenbereich des Halbleiters durch das durchgreifende elektrische Feld zusätzliche negative bzw. positive Ladungsträger influenziert (= Feldeffekt). Beim Anlegen einer Spannung zwischen Source und Drain fließt ein Strom, dessen Höhe von der Spannung zwischen Gate und Source abhängt.

Am bekanntesten ist der sogennante MOS-FET, bei dem das Halbleitermaterial aus einkristallinem Silizium, die Gateisolationsschicht aus einer sehr dünnen (0,1 μm) $SiO_2$-Schicht und die Gateelektrode aus polykristallinem Silizium besteht. Diese Transistoren sind in elektronischen

Edt 1 Plr/5.2.1985

0175215

Schaltungen integriert weit verbreitet. Es sind entweder n-Kanal-Transistoren oder p-Kanal-Transistoren. Ganz allgemein sind FETs als unipolare Bauelemente bekannt.

Aufgabe der Erfindung ist es, einen FET anzugeben, dessen Kanal je nach Größe und Polarität der Drain- und Gate-Spannungen entweder p-leitend oder n-leitend ist.

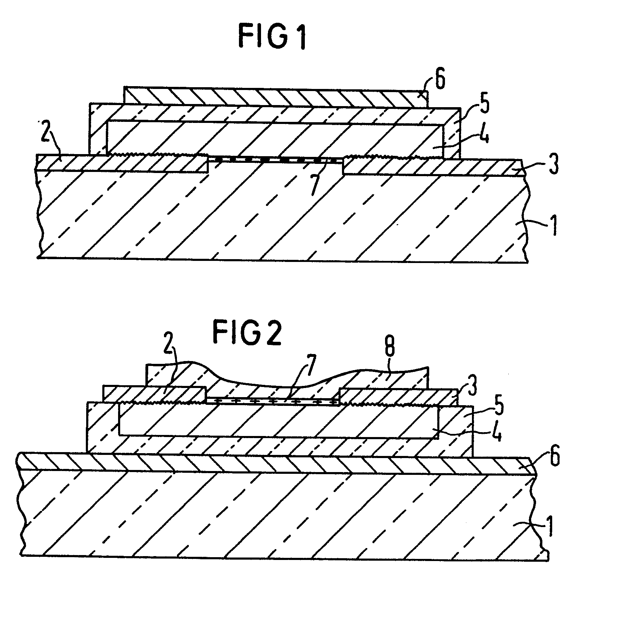

Diese Aufgabe wird durch ein Feldeffekt-Halbleiterbauelement der eingangs genannten Art dadurch gelöst, daß die Source-Basis- und die Drain-Basis-Übergänge als ohmsche Kontakte ausgebildet sind, die Basisschicht eigenleitend oder schwach dotiert ist und daß die der Gateelektrode gegenüberliegende Basisrückseite eine fixe Oberflächenladung trägt, welche eine Majoritätsträgerverarmungszone schafft. Diese Oberflächenladung stellt sich als Grenzflächenladung ein, entweder an der Grenze Basis-Substrat (Figur 1) oder an der Grenze zwischen der Basis und einer Schutzschicht (Figur 2).

Der erfindungsgemäße FET unterscheidet sich vom üblichen unipolaren FET dadurch, daß er keinen "pinch-off" kennt. Zwar tritt Stromsättigung in der Ausgangskennlinie durchaus auch auf, aber mit wechselnder Drain-Spannung kommt ein Quasidurchbruch zum Tragen, weil vom Drain her Löcher einströmen, wenn Elektronen bei Source überwiegen. An einer bestimmten Stelle im Kanal ist dann der lokale Leitwert minimal (und das elektrische Feld maximal). Diese Verhältnisse sind deshalb möglich, weil ohmsche Kontakte ja keinen Ladungsträgertyp blockieren.

Zum Kanalleitwert tragen Elektronen und Löcher bei, welche vom Feldeffekt gegeneinander verschoben sind. Der lokale Leitwert ändert sich zwischen Source und Drain, ebenso das Verhältnis der Beiträge von Elektronen und Löchern zum Leitwert. So kann es vorkommen, daß bei Source der Elektronenleitwert überwiegt und bei Drain der Löcherleitwert (oder umgekehrt). Wir sprechen von einem ambipolaren FET im Gegensatz zu dem gewohnten unipolaren FET.

Es liegt im Rahmen der Erfindung, die Basischicht beidseitig von dielektrischen Schichten mit nachfolgenden
Gateelektroden zu bedecken, wobei die beiden Gates unabhängig voneinander betrieben werden können oder parallel
geschaltet sind.

Eine Anordnung, bei der auf beiden Basisseiten ein isoliertes Gate vorgesehen ist, also eine MISIM- (= metalinsulator-semiconductor-insulator-metal) Struktur, ist
aus einem Aufsatz von P. W. Barth aus dem IEEE Transactions on Electron Devices, Vol. ED-30, No. 12 (1983),
Seiten 1717 - 1726 bekannt. Bei der "Doppelsteuerung"
eines Dünnfilmtransistors in Verbindung mit ohmschen Kontakten nach der Erfindung wird der Schichtleitwert von
beiden Gates beeinflußt, weil dann sowohl Anreicherungsals auch Inversionsschichten auf beiden Basisseiten
direkt zum Kanalstrom beitragen.

Das Dünnschichtkonzept mit ohmschen Kontakten ist sowohl
anwendbar auf großflächige Transistoren, als auch auf
Kurzkanaltransistoren. Da ohmsche Kontakte keine Raumladungszone aufweisen, steht der Verkleinerung der Kanallänge entsprechender Transistoren die punch-through-Gefahr nicht im Wege. Mit ohmschen Kontakten lassen sich
also kürzere Kanallängen erreichen als mit gleichrichtenden Kontakten. Bei kurzen Kanallängen ist auf genügend
großen "Aus"-Widerstand zu achten. Im Falle ohmscher Kontakte sollten im Aus-Zustand möglichst alle Majoritätsträger des schwach dotierten Films über dessen ganze
Breite "ausgeräumt" sein. Wenn nur ein Gate vorgesehen
ist, müßte die Schicht entsprechend dünn sein. Eine fixe
Oberflächenladung auf der Schichtrückseite, gerade so
eingestellt, daß schon dadurch die Majoritätsträger
(wenigstens bis zur Schichtmitte) ausgeräumt sind, dient zur Sicherstellung des größtmöglichen "Aus"-Widerstandes.

Folgende Überlegungen haben zu der Erfindung geführt:

FETs auf der Basis von amorphem Silizium mit aufgesputterten Silber-Schichten als Source-Drain-Kontakte verhalten sich nach unserer Beobachtung "ambipolar", das heißt, sie zeigen jene charakteristischen Kennlinien, die wir im Falle ohmscher Kontakte erwarten. Nun ist der unipolare FET durch das Pao-Sah-Modell (Pao und Sah: Sol. St. Electronics 9, 1966, Seiten 927 bis 937) grundsätzlich verstanden worden. Dieses (eindimensionale) Modell simuliert die Randbedingungen bei Source und Drain dadurch, daß nur ein Ladungsträgetyp am Stromtransport durch den Kanal beteiligt sein darf. Zur Beschreibung des ambipolaren FET funktionieren wir das Pao-Sah-Modell um. Elektronen und Löcher sollen nämlich im Boltzmann-Gleichgewicht zueinander stehen. Diese Situation ist zunächst an den ohmschen Kontakten gegeben. Sie ist aber generell mit dem Feldeffekt verträglich. Man denke zum Vergleich an einen stromlosen pn-Übergang. Stromlosigkeit gilt auch für einen FET in vertikaler Richtung, jedenfalls im Rahmen der beim PaoSah-Modell berücksichtigten "gradual channel approximation". Die grundsätzliche Übereinstimmung zwischen dem abgewandelten Pao-Sah-Modell und unseren Beobachtungen stellt das Konzept und die Realisierbarkeit von ambipolaren FETs sicher. Da unser Konzept im Prinzip einfach und einleuchtend ist, sollte es sich nicht nur mit Schichten aus amorphem Silizium realisieren lassen, sondern auch mit Schichten aus beliebigen anderen Halbleitermaterialien, sofern sie nur sowohl n- als auch p-leitend sein können. Die Dicke der Halbleiterschicht eines ambipolaren FET sollte die Debyelänge nicht wesentlich übertreffen.

Amorphe Silizium-Schichten lassen sich durch verschiedene Methoden niederschlagen (Glimmentladung, Sputtern, CVD = chemical vapor deposition). Neben amorphem Silizium kommt für ambipolare FETs insbesondere das sogenannte mikrokristalline Silizium in Frage (auch durch Glimmentladung abzuscheiden), oder das übliche Polysilizium (CVD). Auch einkristallines Silizium ist geeignet, zum Beispiel im Rahmen der SOI-Technologie (= silicon on insulator-Technologie), ferner die III-V-Verbindungen und von den II-VI-Verbindungen Cadmiumtellurid.

Zur Abscheidung von Halbleiterdünnschichten tritt immer mehr das MBE-Verfahren in den Vordergrund (= molecular beam epitaxy = Molekularstrahl-Epitaxie). Dieses Verfahren erscheint als sehr gut geeignet, um ambipolare FETs herzustellen (auf der Basis von amorphen, polykristallinen und einkristallinen Schichten).

Die Anbringung ohmscher Kontakte an eine schwach dotierte oder gar eigenleitende Halbleiterschicht ist ein wesentlicher Schritt bei der Herstellung ambipolarer FETs. Aufsputtern von Metallschichten ist eine Möglichkeit, oder Versetzen der Source- und Drain-Bereiche mit rekombinierenden Fremdatomen, oder "Aufrauhen" durch Ionenimplantation (mit Stickstoff oder Argon oder dergleichen).

Als Substrat kommt speziell eine $SiO_2$-Schicht über einem Silizium-Einkristall in Frage, um so einen Schritt in Richtung "dreidimensionale Integration" zu machen. Mehrere Schritte sind möglich.

Ein ambipolarer FET kann Verwendung finden als n-Kanal- oder p-Kanal-Transistor oder auch beides. Durch unterschiedliches Dotieren der Halbleiterschicht läßt sich entweder die p-Leitung oder die n-Leitung eines FETs begünstigen. Die unkonventionellen Eigenschaften solcher FETs (wie zum Beispiel Quasidurchbruch) eröffnen dem Schaltungstechniker darüber hinaus ganz unerwartete Möglichkeiten.

Die Erfindung und vorteilhafte Einzelheiten der Erfindung werden im folgenden anhand der Figuren 1 bis 10 noch näher erläutert. Dabei zeigen

die Figuren 1 bis 3 im Schnittbild den Aufbau eines FET nach der Erfindung,

die Figuren 4 und 5 Ausgangskennlinien eines herkömmlichen n-Kanal-FET bzw. p-Kanal-FET und

die Figuren 6 bis 10 die Ausgangskennlinien eines erfindungsgemäßen ambipolaren-FET.

In den Figuren 1 bis 3 gelten folgende Bezugszeichen:

1 = isolierendes Substrat aus zum Beispiel Glas, Saphir oder $SiO_2$,

2 = Drain-Kontakt aus zum Beispiel Aluminium oder Silber,

3 = Source-Kontakt aus zum Beispiel Aluminium oder Silber,

4 = aktive Halbleiterschicht als Transistorbasis zum Beispiel aus mikrokristallinem oder polykristallinem Silizium,

5, 5a = Dielektrikum zum Beispiel aus $SiO_2$ oder Siliziumnitrid,

6, 6a = Gate-Elektrode aus zum Beispiel Aluminium oder starkdotiertem polykristallinem Silizium,

7 = Grenzflächenladung,

8 = Schutzschicht aus isolierendem Material (zum Beispiel $SiO_2$).

Der Unterschied zwischen den Ausführungsbeispielen gemäß Figur 1 und Figur 2 besteht darin, daß in Figur 1 die Source- und Drain-Kontakte unmittelbar auf dem Substrat liegen und die Gate-Elektrode sich oben befindet, während in Figur 2 das Umgekehrte der Fall ist und die Oberfläche mit einer Schutzschicht (8) bedeckt ist.

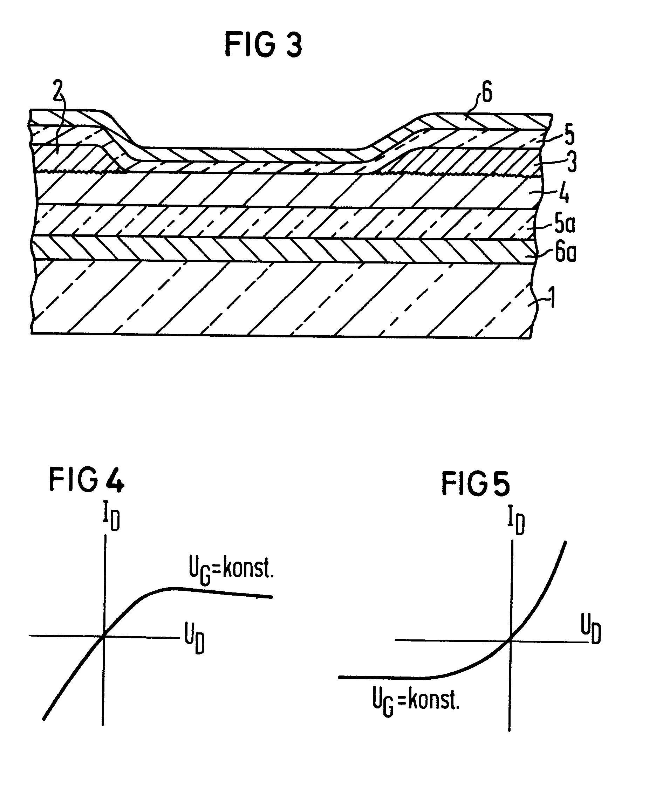

Die Figur 3 stellt eine Kombination der Figuren 1 und 2 dar. Die Anordnung besitzt zwei isolierte Gate-Elektroden (5, 5a, 6, 6a), die unabhängig voneinander betrieben werden können, oder parallel geschaltet sind.

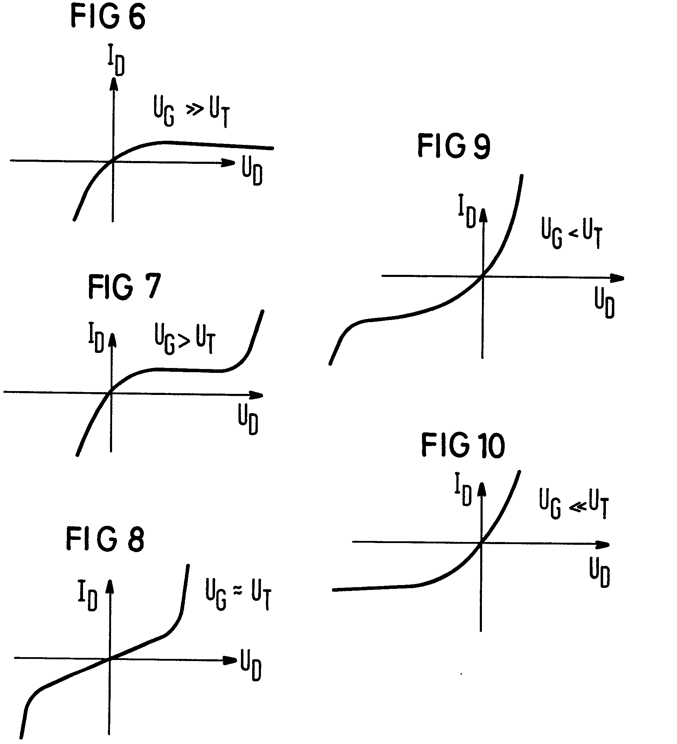

Die Figuren 4 und 5 zeigen die Abhängigkeit des Drainstromes $I_D$ von der Drainspannung $U_D$ für einen normalen n-Kanal-FET (Figur 4) und für einen normalen p-Kanal-FET (Figur 5).

Die Figuren 6 bis 10 zeigen die Ausgangskennlinien eines ambipolaren FET mit geerdeter Source-Elektrode. Bei $U_T$ (transition-voltage ersetzt die herkömmliche thresholdvoltage) ist der (mittlere) Kanalleitwert minimal.

Dabei zeigt die Figur 6 die Abhängigkeit des Drainstromes von der Drainspannung, wenn die Gatespannung $U_G$ sehr viel größer als die Schwellspannung $U_T$ ist (Elektronenregime),

die Figur 7 bei $U_G > U_T$; der Quasidurchbruch ist als plötzlicher Anstieg von $I_D$ bei einer bestimmten Spannung $U_D > 0$ zu erkennen,

die Figur 8, wenn $U_G \approx U_T$ (= ausgeartete Kennlinie ohne Stromsättigung),

die Figur 9 bei $U_G < U_T$; der Quasidurchbruch ist als plötzlicher Anstieg des Betrages von $I_D$ bei einer bestimmten Spannung $U_D < 0$ zu erkennen und

0175215

die Figur 10 bei $U_G \ll U_T$ (Löcherregime).

10 Patentansprüche
10 Figuren

Patentansprüche

1. Feldeffekt-Halbleiterbauelement in Dünnschichtbauweise mit einer auf der Oberfläche eines isolierenden Substrats (1) aufgebrachten Halbleitermaterialschicht als Basisschicht (4), die zwischen zwei als Source (3) und Drain (2) wirkenden Bereichen einen leitenden Kanal bildet, dessen Vorderseite von einer Steuerelektrode (Gate) (6) durch eine elektrisch-isolierende Zwischenschicht (5) getrennt ist, d a d u r c h   g e k e n n z e i c h n - n e t ,   daß der Source-Basis-Übergang (3, 4) und der Drain-Basis-Übergang (2, 4) als ohmsche Kontakte ausgebildet sind, die Basisschicht (4) eigenleitend oder schwach dotiert ist und daß die der Gate-Elektrode (6) gegenüberliegende Basisrückseite eine fixe Grenzflächenladung (7) trägt, die eine Majoritätsträgerverarmungszone schafft (Figur 1 oder 2).

2. Feldeffekt-Halbleiterbauelement nach Anspruch 1, d a d u r c h   g e k e n n z e i c h n e t ,   daß die Basisschicht (4) beidseitig von dielektrischen Schichten (5 und 5a) mit nachfolgenden Gateelektroden (6 und 6a) bedeckt ist, wobei die beiden Gates unabhängig voneinander betrieben werden können oder parallel geschaltet sind (Figur 3).

3. Feldeffekt-Halbleiterbauelement nach Anspruch 1 und/oder 2, d a d u r c h   g e k e n n z e i c h n e t , daß die die Basis bildende Halbleitermaterialschicht (4) aus Silizium in amorpher, mikrokristalliner, polykristalliner oder einkristalliner Form besteht.

4. Feldeffekt-Halbleiterbauelement nach Anspruch 3, d a d u r c h   g e k e n n z e i c h n e t ,   daß bei Vorliegen einer einkristallinen Siliziumschicht (4) die SOI (= silicon on insulator-Technik) verwendet ist.

5. Feldeffekt-Halbleiterbauelement nach Anspruch 1 und/oder 2, d a d u r c h  g e k e n n z e i c h n e t , daß die die Basis bildende Halbleitermaterialschicht (4) aus einer III-V-Verbindung, vorzugsweise aus Galliumarsenid oder Indiumantimonid besteht.

6. Feldeffekt-Halbleiterbauelement nach Anspruch 1 und/oder 2, d a d u r c h  g e k e n n z e i c h n e t , daß die die Basis bildende Halbleitermaterialschicht (4) aus einer II-VI-Verbindung, vorzugsweise Cadmiumtellurid besteht.

7. Feldeffekt-Halbleiterbauelement nach mindestens einem der Ansprüche 1 bis 6, d a d u r c h  g e k e n n - z e i c h n e t , daß die die Basis bildende Halbleitermaterialschicht (4) durch Molekularstrahl-Epitaxie erzeugt ist.

8. Feldeffekt-Halbleiterbauelement nach mindestens einem der Ansprüche 1 bis 7, d a d u r c h  g e k e n n - z e i c h n e t , daß die als Source (3) und Drain (2) wirkenden ohmschen Kontakte durch Kathodenzerstäubung (Sputtern) von Metallen, beispielsweise Silber, erzeugt sind (Figur 2).

9. Feldeffekt-Halbleiterbauelement nach mindestens einem der Ansprüche 1 bis 7, d a d u r c h  g e k e n n - z e i c h n e t , daß die für die ohmschen Kontakte (2, 3) vorgesehenen Bereiche der Basisschicht (4) Kri- stallgitterstörungen aufweisen, die durch Ionenimplan- tation von beispielsweise Stickstoff- oder Argon-Ionen erzeugt sind.

10. Feldeffekt-Halbleiterbauelement nach mindestens einem der Ansprüche 1 bis 8, d a d u r c h  g e k e n n - z e i c h n e t , daß die für die ohmschen Kontakte (2, 3) vorgesehenen Bereiche der Basisschicht (4) durch Do-

0175215

tierung mit Fremdatomen in ihrer Lebensdauer herabgesetzt sind.

## FIG 1

## FIG 2

0175215

## FIG 3

## FIG 4

$I_D$

$U_G$=konst.

$U_D$

## FIG 5

$I_D$

$U_D$

$U_G$=konst.

FIG 6

$I_D$

$U_G \gg U_T$

$U_D$

FIG 7

$I_D$   $U_G > U_T$

$U_D$

FIG 8

$I_D$   $U_G \approx U_T$

$U_D$

FIG 9

$I_D$

$U_G < U_T$

$U_D$

FIG 10

$I_D$   $U_G \ll U_T$

$U_D$

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE-B-1 514 337 (RCA CORP.) <br> * Anspruch 1; Spalte 3, Zeilen 60-65; Figur 1 * | 1 | H 01 L 29/78 |
| A | * Spalte 1, Zeilen 1-10,34-41 * | 3,5,6 | |
| Y | US-A-3 671 820 (R.R. HAERING et al.) <br> * Spalte 3, Zeile 31 - Spalte 4, Zeile 3 * | 1 | |
| A | FR-A-2 132 717 (WESTINGHOUSE ELECTRIC CORP.) <br> * Seite 3, Zeilen 17-35; Figur 1 * | 3-6,8 | |
| A | SOLID-STATE ELECTRONICS, Band 24, Nr. 3, März 1981, Seiten 257-261, Pergamon Press Ltd., Exeter, GB; I. CHEN et al.: "Electronic characterization of double-gate thin film transistors" <br> * Zusammenfassung; Figur 1 * | 1,2 | RECHERCHIERTE SACHGEBIETE (Int. Cl.4) <br><br> H 01 L |

--- -/-

Der vorliegende Recherchenbericht wurde für alle Patentansprüche erstellt.

| Recherchenort | Abschlußdatum der Recherche | Prüfer |
|---|---|---|
| DEN HAAG | 27-11-1985 | ZOLLFRANK G.O. |

Europäisches
Patentamt

**EUROPÄISCHER RECHERCHENBERICHT**

0175215
Nummer der Anmeldung

EP 85 11 1180

Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | JAPANESE JOURNAL OF APPLIED PHYSICS, Band 22, Suppl. 22-1, 1983, Seiten 497-500, Tokyo, JP; M. MATSUI et al.: "A 10x10 polycrystalline-silicon thin-film transistor matrix for liquid-crystal display" * Zusammenfassung * | 1,7 | |
| | --- | | |
| A | APPLIED PHYSICS LETTERS, Band 41, Nr. 6, 15. September 1982, Seiten 552-554, American Institute of Physics, New York, US; F.C. LUO et al.: "Forming ohmic contacts in CdSe thin-film transistors by dc sputter etching" | | |
| | ----- | | |

**RECHERCHIERTE SACHGEBIETE (Int. Cl.4)**

Der vorliegende Recherchenbericht wurde für alle Patentansprüche erstellt.

| Recherchenort | Abschlußdatum der Recherche | Prüfer |
|---|---|---|
| DEN HAAG | 27-11-1985 | ZOLLFRANK G.O. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82